# EUROPEAN PATENT SPECIFICATION

(11) **EP 1 629 990 B1**
(45) Date of publication and mention of the grant of the patent: **09.01.2008**
(21) Application number: 05107902.8
(22) Date of filing: 30.08.2005
(51) Int. Cl.: B41M 5/26

(54) **Donor substrate for laser induced thermal imaging and method of fabricating organic light emitting display using the same**
Donorsubstrat zur laserinduzierten thermischen Bebilderung und Verfahren zur Hertellung einer organischen lichtemittierenden Anzeigevorrichtung
Substrat donneur pour la formation d'images induites par laser et procédé de fabrication d'un dispositif d'affichage organique émetteur de lumière

(30) Priority: 30.08.2004 KR 2004068774
(43) Date of publication of application: 01.03.2006
(73) Proprietor: Samsung SDI Co., Ltd., Suwon-si Gyeonggi-do (KR)
(72) Inventor: KIM, Mu-Hyung, Gyeonggi-do (KR); SONG, Myung-Won, Gyeonggi-do (KR); CHIN, Byung-Doo Legal & IP Team Corp. Plan. Staff, Yongin-si Gyeonggi-do (KR); LEE, Seong-Taek, Gyeonggi-do (KR)
(74) Representative: Hengelhaupt, Jürgen

(56) References cited:
- EP-A- 1 329 955
- WO-A-00/41894
- US-B1- 6 221 543

## Description

### CROSS-REFERENCE TO RELATED APPLICATION

This application relies for priority upon Korean Patent Application No. 2004-68774 filed on August 30, 2004.

### BACKGROUND OF THE INVENTION

### 1. Field of the Invention

The present invention relates to a donor substrate for laser induced thermal imaging (LITI) and method of fabricating an organic light emitting display (OLED) using the same substrate and, more particularly, to a donor substrate for LITI and method of fabricating an OLED using the same substrate, which may control the generation of static electricity.

### 2. Description of the Related Art

In recent years, an OLED is quite appropriate for a medium that displays high-resolution moving images because it consumes low power and has high luminous efficiency, a wide viewing angle, and a fast response speed. For these reasons, the OLED has attracted much attention as the next-generation display.

Also, the OLED includes an organic layer including an organic emission layer, which is interposed between an anode and a cathode. The OLED is a self-emissive display in which when a voltage is applied between the anode and the cathode, electrons recombine with holes in the organic emission layer to generate light. Since the OLED does not require a backlight such as a liquid crystal display (LCD), it may be fabricated in a lightweight and thin form by a simple process.

In this case, the OLED may be classified into a small molecular OLED and a polymer OLED according to the material of the organic layer (esp., the organic emission layer).

The small molecular OLED includes a multilayered organic layer having different functions, such as a hole injection layer, a hole transport layer, an emission layer, a hole blocking layer, and an electron injection layer, between an anode and a cathode. To prevent accumulation of charges, a doping process may be performed or a material having an appropriate energy level may be used instead. In this case, since the above-described organic layers are typically formed by a vacuum deposition method, it is difficult to realize a large-sized display.

On the other hand, the polymer OLED includes a single structure of an organic emission layer or a double structure of an organic emission layer and a hole transport layer, between the anode and the cathode. Thus, the polymer OLED may be fabricated to a small thickness. Also, because the organic layer is formed using a wet coating process, it may be formed under normal pressure so that the cost of production may be greatly reduced and the OLED may be easily fabricated on a large area.

In fabricating a monochromatic device, a polymer OLED may be simply fabricated using a spin coating process but is inferior in efficiency and lifetime than a small molecular OLED. Also, a full-color device may be fabricated by patterning red (R), green (G), and blue (B) emission layers on an OLED. Here, an organic layer of the small molecular OLED may be patterned by a deposition method using a shadow mask, while an organic layer of the polymer OLED may be patterned by an inkjet printing process or a laser induced thermal imaging (LITI) process. Since the LITI process directly makes use of the features of the spin coating process, when a large-area organic layer is formed, the uniformity of a pixel may be improved. Also, because the LITI process is not a wet process but a dry process, a reduction in the lifetime of the OLED due to a solvent may be overcome, and the organic layer may be finely patterned.

The application of the LITI process basically requires a light source, an OLED substrate, and a donor substrate. The donor substrate includes a base layer, a light-to-heat conversion (LTHC) layer, and a transfer layer.

During the LITI process, light is emitted from the light source and absorbed in the LTHC layer, thus the light is converted into thermal energy so that an organic material formed on the transfer layer may be transferred onto the substrate due to the thermal energy.

A method of patterning an organic layer on an OLED using the LITI process is disclosed not only in Korea Patent Registration No. 10-0342653 but also in U.S. Patent No. 5,998,085, No. 6,214, 520, and No. 6,114,085. WO 00/41894 A1 refers to another conventional LITI process for manufacturing an OLED.

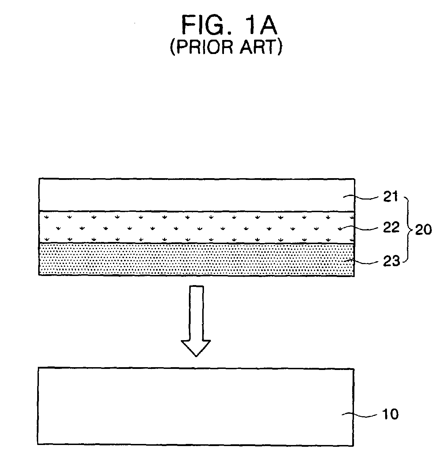

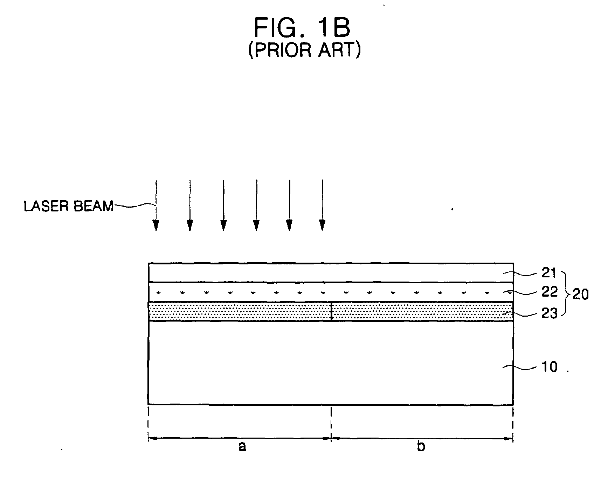

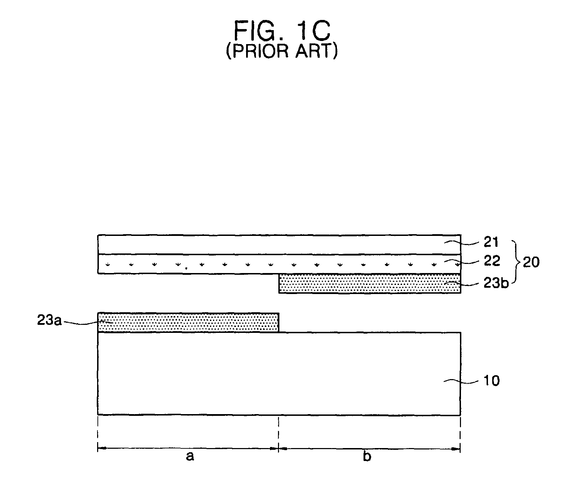

FIGs. 1A to 1C are cross-sectional views illustrating a method of patterning an organic layer 23 using an LITI process.

Referring to FIG. 1A, a substrate 10 is provided, and a donor substrate 20 including a base layer 21, an LTHC layer 22, and the organic layer 23 is laminated on the substrate 10.

Referring to FIG. 1B, laser beams are irradiated onto the base layer 21 of the donor substrate 20 in a first region (a). The laser beams that are transmitted through the base layer 21 are converted into heat in the LTHC layer 22. Owing to the heat, adhesion of the organic layer 23 in the first region (a) with the LTHC layer 22 is weakened.

Referring to FIG. 1C, after the organic layer 23 in the first region (a), which is poorly adhered to the LTHC layer 22, is transferred on the substrate 10, the donor substrate 20 is detached from the substrate 10. Thus, an organic transfer layer 23a is patterned on the substrate 10, and an organic layer 23b in a second region (i.e., a region to which no laser beams are irradiated) (b) is detached from the substrate 10 along with the donor substrate 20. As a result, the organic transfer pattern 23a is completed.

However, in forming the organic transfer pattern 23a using the above-described LITI process, static electricity may arise from rubbing and external environmental factors during the attachment/detachment of the donor substrate 20 to/from the substrate 10. Since a voltage reaches several thousands to several tens of thousands during discharge of static electricity, a junction may have a short circuit, a metal layer may be melted due to a rise in temperature of the OLED, or a junction line may be opened. That is, a failure in the OLED may take place, and an internal circuit in the OLED may be adversely affected to degrade the properties of the OLED.

### SUMMARY OF THE INVENTION

The present invention, therefore, provides a method of fabricating an organic light emitting display (OLED), which may control the generation of static electricity when an organic layer is formed using a laser induced thermal imaging (LITI) process.

According to a first aspect of the present there is provided a donor substrate for LITI including: a base layer; a light-to-heat conversion (LTHC) layer disposed on the entire surface of the base layer; an anti-static layer disposed on the entire surface of the LTHC layer; a transfer layer disposed on the entire surface of the anti-static layer; and a conductive frame disposed on an outer portion of the donor substrate and connected to the anti-static layer.

According to a second aspect of the present there is provided a method of fabricating a donor substrate for LITI including: providing a base layer; forming an LTHC layer on the entire surface of the base layer; forming an anti-static layer on the entire surface of the LTHC layer; forming a transfer layer on the anti-static layer; and forming a conductive frame on an outer portion of the resultant donor substrate. Herein, the anti-static layer is connected to the frame.

According to a third aspect of the present there is provided a method of fabricating an OLED including: patterning a first electrode on a substrate; fixedly adsorbing the substrate to a stage that is transferable and grounded; disposing the donor substrate fixed by a frame opposite to a pixel region of the substrate; transferring an organic layer including at least an emission layer to the donor substrate by selectively irradiating laser beams on the donor substrate; detaching the donor substrate from the substrate; and forming a second electrode on the entire surface of the substrate including the organic layer.

### BRIEF DESCRIPTION OF THE DRAWINGS

The above and other advantages of the present invention will become more apparent by describing in detail the preferred embodiments thereof with reference to the accompanying drawings, in which:
FIGs. 1A to 1C are cross-sectional views illustrating a process of patterning an organic layer using a laser induced thermal imaging (LITI) method;
FIG. 2 is a cross-sectional view of a donor substrate according to an exemplary embodiment of the present invention; and
FiGs. 3A to 3C are cross-sectional views illustrating a method of fabricating an organic light emitting display (OLED) according to an exemplary embodiment of the present invention.

### DETAILED DESCRIPTION

The present invention will now be described more fully hereinafter with reference to the accompanying drawings, in which exemplary embodiments of the invention are shown.

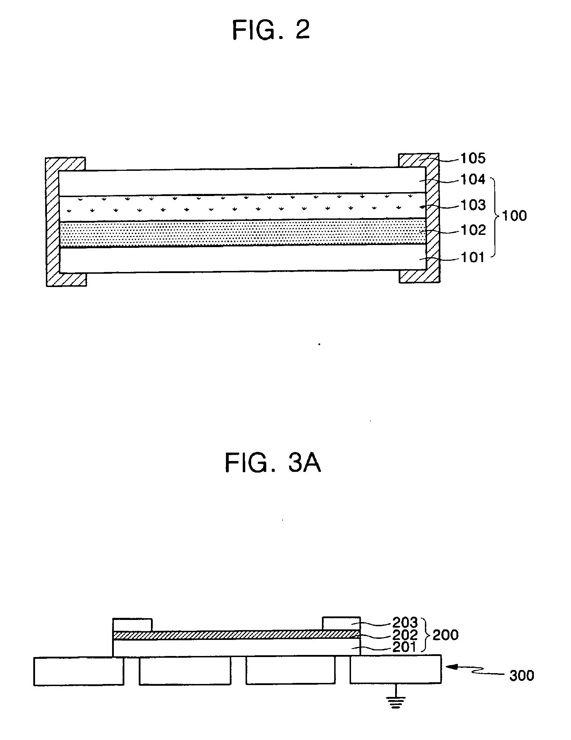

FIG. 2 is a cross-sectional view of a donor substrate 100 according to an exemplary embodiment of the present invention.

Referring to FIG. 2, the donor substrate 100 includes a base layer 101 and a light-to-heat conversion (LTHC) layer 102, an anti-static layer 103, and a transfer layer 104 that are sequentially stacked on the base layer 101. A frame 105 formed of a conductive material is attached to an outer portion of the donor substrate 100.

The base layer 101 should be transparent such that light is transmitted to the LTHC layer 102. The base layer 101 may be formed of a polymer having appropriate optical properties and sufficient mechanical stability. The base layer 101 may be formed of at least one polymer selected from the group consisting of polyester, polyacryl, polyepoxy, polyethylene, and polystyrene. More preferably, the base layer 101 may be formed of polyethylene terephthalate (PET).

The LTHC layer 102 absorbs light in the infrared (IR)-visible (V) region and converts a part of the light into heat. The LTHC layer 102 should have appropriate optical density and may be formed of a light absorbing material to absorb light. Here, the LTHC layer 102 may be a metal layer formed of Al, Ag, oxide thereof, or sulfide thereof or a polymer organic layer formed of carbon black, black lead, or an IR dye. The metal layer may be formed using a vacuum deposition method, an electronic beam (e-beam) deposition method, or a sputtering method, and the organic layer may be formed of a typical film coating method, for example, one of a roll coating process, a photogravure process, an extrusion process, a spin coating process, and a knife coating process.

The anti-static layer (interlayer) 103 serves to suppress static electricity that may occur when the donor substrate 100 is adhered to the substrate (not shown) or when the donor substrate 100 is detached from the substrate after an LITI process. The anti-static layer 104 of the donor substrate 100 is connected to the frame 105, and the frame 105 is connected to a grounded stage, thus suppressing the generation of static electricity. The anti-static layer 103 may be formed of one of an organic material, an inorganic material, and a combination thereof. For instance, the organic material may be one conductive polymer selected from the group consisting of polyaniline, polypyrrole, polythiophene, and poly(3,4-ethylenedioxythiophene). When the anti-static layer 103 is formed of a conductive polymer, it may be formed to a uniform thickness using a wet coating process. Also, the inorganic material may be one material selected from the group consisting of antimony tin oxide (ATO), indium tin oxide (ITO), indium zinc oxide (IZO), Nb₂O₃, ZnO, and TiN. When the anti-static layer 103 is formed of an inorganic material, it may be highly conductive, control static electricity efficiently, and have durability. Also, the combination of the organic and inorganic materials may be one material selected from the group consisting of an ATO sol, an ITO sol, Ag-Pd, and Ag-Ru. Since the combination of the organic and inorganic materials is in a sol state, it is advantageous to the formation of a thin layer and the increase of conductivity.

The transfer layer 104 may be one layer selected from the group consisting of an organic emission layer, an organic hole injection layer, an organic hole transport layer, an organic hole blocking layer, an organic electron injection layer, an organic electron transport layer, and a laminated layer thereof.

The transfer layer 104 may be formed by an extrusion process, a spin coating process, a knife coating process, a vacuum deposition process, or a chemical vapor deposition (CVD) process.

Also, an intermediate layer may be additionally disposed between the anti-static layer 103 and the transfer layer 104 to enhance the transfer characteristics. In this case, the intermediate layer may include at least one of a gas generation layer, a buffer layer, and a metal reflective layer.

The gas generation layer absorbs light or heat and causes a decomposition reaction, thus it emits N₂ gas or H₂ gas to provide transfer energy. The gas generation layer may be formed of pentaerythrite tetranitrate or trinitrotoluene.

The buffer layer serves to prevent a light-heat absorbing material from contaminating or damaging the transfer layer 104 that will be formed in a subsequent process. Also, the buffer layer controls adhesion of the anti-static layer 103 with the transfer layer 104, thus improving the transfer pattern characteristics. Here, the buffer layer may be formed of a metal oxide, a non-metal inorganic compound, or an inert polymer.

The metal reflective layer reflects laser beams irradiated onto the base layer 101 of the donor substrate 100 so that more energy is applied to the LTHC layer 102. Also, when the gas generation layer is additionally disposed, the metal reflective layer serves to prevent a gas generated by the gas generation layer from diffusing into the transfer layer 104.

As described above, the frame 105 that is attached to the outer portion of the donor substrate 100 may be formed of a conductive material. In this case, the conductive material may be one of an organic material, an inorganic material, and a combination thereof. For example, the organic material may be a conductive polymer selected from the group consisting of polyaniline, polypyrrole, polythiophene, and poly(3,4-ethylenedioxythiophene). Also, the inorganic material may be one material selected from the group consisting of ATO, ITO, IZO, Nb₂O₃, ZnO, and TiN. The frame 105 formed of an inorganic material is highly conductive, controls static electricity efficiently, and has durability. Also, the combination of the organic and inorganic materials may be one material selected from the group consisting of an ATO sol, an ITO sol, Ag-Pd, and Ag-Ru.

The anti-static layer 104 of the donor substrate 100 is directly connected or electrically connected to the frame 105. During an LITI process, the frame 105 is connected to the grounded stage, thus controlling static electricity that may arise from the LITI process.

In this case, the frame 105 keeps the donor substrate 100 flattened. Thus, the substrate may be adhered to the donor substrate 100 without sagging in the donor substrate 100 during a subsequent LITI process. As a result, the transfer characteristics is improved. Further, after the transfer layer 104 is formed using the LITI process, the donor substrate 100 may be easily detached from the substrate using the frame 105.

Hereinafter, a method of fabricating an organic light emitting display (OLED) through an LITI process using a donor substrate according to an exemplary embodiment of the present invention will be described with reference to FIGs. 3A to 3C.

Referring to FIG. 3A, a substrate suction stage 300 on which a substrate 200 is grounded is provided.

Here, the substrate 200 includes a first electrode 202, which is formed on an insulating substrate 201 using a typical method, and a pixel defining layer 203, which is formed on the first electrode 202 to define a pixel portion. Also, the substrate 200 may include a thin film transistor (TFT) and a plurality of insulating layers. When the first electrode 202 is an anode, it may be a transparent electrode, which is formed of a metal having a high work function, such as ITO or IZO, or a reflective electrode, which is formed of one material selected from the group consisting of Pt, Au, Ir, Cr, Mg, Ag, Ni, Al, and an alloy thereof.

When the first electrode 202 is a cathode, it may be a thin transparent electrode, which is formed of a metal having a low work function that is selected from the group consisting of Mg, Ca, Al, Ag, Ba, and an alloy thereof, or a thick reflective electrode.

Meanwhile, the substrate suction stage 300 is grounded and is a unit that fixedly adsorbs and moves the substrate 200 using a suction portion 300a.

In addition, a donor substrate 100, which has an outer portion to which a conductive frame 105 is attached, is fabricated according to the exemplary embodiment of the present invention. The donor substrate 100 includes a base layer 101, an LTHC layer 102, an anti-static layer 103, and a transfer layer 104. Here, the anti-static layer 103 is connected to the frame 105.

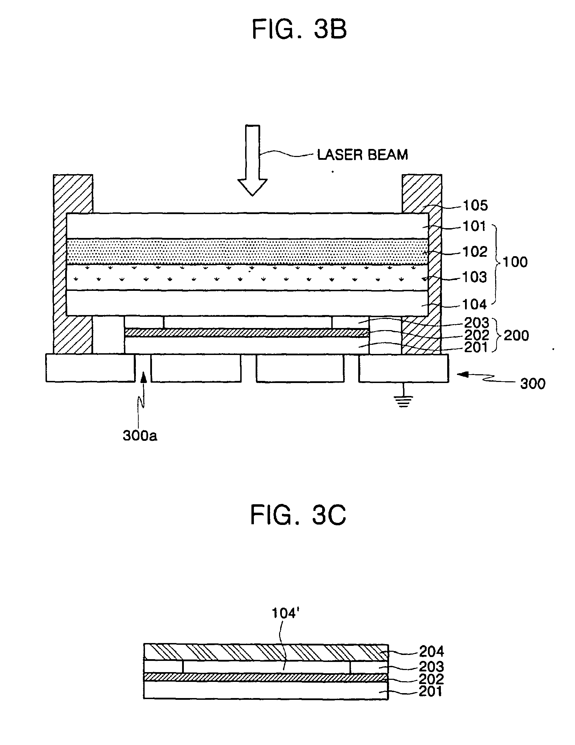

Referring to FIG. 3B, the donor substrate 100 having the frame 105 is adhered to the substrate 200, which is adsorbed and fixed to the stage 300, such that the donor substrate 100 faces a pixel region of the substrate 200. The anti-static layer 103 of the donor substrate 100 is connected to the frame 105, and the frame 105 is connected to the grounded stage 300.

Thereafter, laser beams are irradiated on a predetermined region of the donor substrate 100, thus transferring the transfer layer 101 onto the pixel region of the first electrode 202.

In this case, the transfer layer 104 includes at least an organic emission layer and may further include at least one selected from the group consisting of a hole injection layer, a hole transport layer, a hole blocking layer, an electron transport layer, and an electron injection layer to enhance the properties of the OLED.

The organic emission layer may be formed of a red light emitting material, which is a small molecular material such as Alq3(host)/DCJTB(fluorescent dopant), Alq3(host)/DCM(fluorescent dopant), and CBP(host)/PtOEP(phosphorescent organic metal complex) or a polymer such as a PFO-based polymer and a PPV-based polymer. The organic emission layer may be formed of a green light emitting material, which is a small molecular material such as Alq3, Alq3(host)/C545t(dopant), and CBP(host)/IrPPy(phosphorescent organic metal complex) or a polymer such as a PFO-based polymer and a PPV-based polymer. Also, the organic emission layer may be formed of a blue light emitting material, which is a small molecular material such as DPVBi, spiro-DPVBi, spiro-6P, distilled benzene (DSB), and distilled arylene (DSA) or a polymer such as a PFO-based polymer and a PPV-based polymer.

When the first electrode 202 is an anode, a hole injection layer is formed on the first electrode 202. In this case, the hole injection layer is formed of a material that is highly adhesive to the first electrode 202 and requires low ionization energy in order to facilitate injection of holes and increase the lifetime of the OLED. The hole injection layer may be formed of an aryl aminic compound, a porphyrin-based metal complex, or a starburst amine. More specifically, the hole injection layer may be formed of 4,4',4"-tris(3-methylphenyl-phenylamino)-triphenylamine (m-MTDATA), 1,3,5-tris[4-(3-methyl-phenyl-phenyl-amino)phenyl]benzene(m-MTDATB), or phthalocyanine copper (CuPc).

The hole transport layer makes it easy to transport holes to the emission layer and keeps electrons generated by a second electrode (not shown) from moving to an emission region, thus increasing the luminous efficiency of the OLED. The hole transport layer may be formed of an arylene diamine derivative, a starburst compound, a biphenyl diamine derivative with a spiro radical, or a trapezoidal compound. More specifically, the hole transport layer may be formed of N,N-diphenyl-N,N'-bis(4-methyl-phenyl)-1,1'-biphenyl-4,4'-diamine(TPD), or 4,4'-bis[N-(1-naphtyle)-N-phenyl-amino]biphenyl(NPB).

The hole blocking layer prevents deterioration of luminous efficiency, which may be lowered because hole mobility is higher than electron mobility in the organic emission layer and excitons formed in the emission layer are distributed in a wide range. The hole blocking layer may be formed of one selected from the group consisting of 2-biphenyl-4-yl-5-(4-t-butylphenyl)-1,3,4-oxydiazol(PBD), spiro-PBD, and 3-(4'-tert-butylphenyl)-4-phenyl-5-(4'-biphenyl)-1,2,4-triazol(TAZ).

The electron transport layer may be stacked on the organic emission layer and formed of an electron-receptive metal compound. For example, the electron transport layer may be formed of 8-(hydroquinoline) aluminum (Alq3), which may stably receive electrons transported from the second electrode.

In this case, the organic layer may be formed by a spin coating process or a deposition process. Alternatively, while the transfer layer 104 is being formed on the donor substrate 100 using an LITI process, one of the organic emission layer and the organic layers may be formed at the same time.

Referring to FIG. 3C, after the transfer layer 104 is transferred onto the first electrode 202, the donor substrate 100 is detached from the substrate 200, thus forming an organic layer pattern 104'. Thereafter, a second electrode 204 is formed on the organic layer pattern 104'. Although not shown in the drawings, the resultant structure is encapsulated using an encapsulation substrate or a metal can, thereby completing the OLED.

When the second electrode 204 is a cathode, it may be a thin transparent electrode, which is formed of a metal having a low work function that is selected from the group consisting of Mg, Ca, Al, Ag, and an alloy thereof, or a thick reflective electrode.

Also, when the second electrode 204 is an anode, it may be a transparent electrode, which is formed of a metal having a high work function, such as ITO or IZO, or a reflective electrode, which is formed of one material selected from the group consisting of Pt, Au, lr, Cr, Mg, Ag, Ni, Al, and an alloy thereof.

As described above, the present invention effectively controls static electricity that may arise during the fabrication of an OLED using an LITI process. Hence, deterioration of the OLED due to the static electricity is prevented, thus realizing a high-quality OLED.

Further, in the present invention, a frame is formed on an outer portion of a donor substrate. Thus, a transfer layer may be effectively formed through the LITI process, and the donor substrate may be easily attached to or detached from a substrate to increase productivity.

## Claims

1. A donor substrate for laser induced thermal imaging comprising:
a base layer;
a light-to-heat conversion layer disposed on the entire surface of the base layer;
an anti-static layer disposed on the entire surface of the light-to-heat conversion layer;
a transfer layer disposed on the entire surface of the anti-static layer; and
a conductive frame disposed on an outer portion of the donor substrate and connected to the anti-static layer.

2. The donor substrate according to claim 1, wherein the conductive frame is formed of one selected from a group consisting of an organic material, an inorganic material, and a combination thereof.

3. The donor substrate according to claim 2, wherein the organic material is one selected from a group consisting of polyaniline, polypyrrole, polythiophene, and poly(3,4-ethylenedioxythiophene).

4. The donor substrate according to claim 2, wherein the inorganic material is one selected from a group consisting of antimony tin oxide (ATO), indium tin oxide (ITO), indium zinc oxide (IZO), Nb₂O₃, ZnO, and TiN.

5. The donor substrate according to claim 2, wherein the combination of the organic and inorganic materials is one selected from a group consisting of an ATO sol, an ITO sol, Ag-Pd, and Ag-Ru.

6. The donor substrate according to claim 1, wherein the anti-static layer is formed of a conductive material.

7. The donor substrate according to claim 6, wherein the conductive material is one selected from a group consisting of polyaniline, polypyrrole, polythiophene, poly(3,4-ethylenedioxythiophene), ATO, ITO, IZO, Nb₂O₃, ZnO, TiN, an ATO sol, an ITO sol, Ag-Pd, and Ag-Ru.

8. The donor substrate according to claim 1, wherein the light-to-heat conversion layer is formed of one selected from a group consisting of an organic layer, a metal, an oxide or sulfide of the metal, and an alloy thereof, that contain a light absorbing material.

9. The donor substrate according to claim 1, wherein the base layer is formed of one of a glass substrate and a transparent polymer that is selected from a group consisting of polyester, polyacryl, polyepoxy, polyethylene, and polystyrene.

10. The donor substrate according to claim 1, further comprising an intermediate layer interposed between the anti-static layer and the transfer layer.

11. The donor substrate according to claim 10, wherein the intermediate layer includes at least one selected from a group consisting of a gas generation layer, a buffer layer, and a metal thin layer.

12. The donor substrate according to claim 1, wherein the transfer layer is one selected from a group consisting of an organic emission layer, an organic hole injection layer, an organic hole transport layer, an organic hole blocking layer, an organic electron injection layer, an organic electron transport layer, and a laminated layer thereof.

13. A method of fabricating a donor substrate for laser induced thermal imaging, comprising:
providing a base layer;
forming a light-to-heat conversion layer on the entire surface of the base layer;
forming an anti-static layer on the entire surface of the light-to-heat conversion layer;
forming a transfer layer on the anti-static layer; and
forming a conductive frame on an outer portion of the resultant donor substrate,
wherein the anti-static layer is connected to the conductive frame.

14. The method according to claim 13, wherein the conductive frame is formed of one selected from a group consisting of an organic material, an inorganic material, and a combination thereof.

15. The method according to claim 14, wherein the organic material is one selected from a group consisting of polyaniline, polypyrrole, polythiophene, and poly(3,4-ethylenedioxythiophene).

16. The method according to claim 14, wherein the inorganic material is one selected from a group consisting of ATO, ITO, IZO, Nb₂O₃, ZnO, and TiN.

17. The method according to claim 14, wherein the combination of the organic and inorganic materials is one selected from a group consisting of an ATO sol, an ITO sol, Ag-Pd, and Ag-Ru.

18. The method according to claim 13, wherein the anti-static layer is formed of a conductive material.

19. The method according to claim 18, wherein the conductive material is one selected from a group consisting of polyaniline, polypyrrole, polythiophene, poly(3,4-ethylenedioxythiophene), ATO, ITO, IZO, Nb₂O₃, ZnO, TiN, an ATO sol, an ITO sol, Ag-Pd, and Ag-Ru.

20. The method according to claim 13, wherein the transfer layer is one selected from a group consisting of an organic emission layer, an organic hole injection layer, an organic hole transport layer, an organic hole blocking layer, an organic electron injection layer, an organic electron transport layer, and a laminated layer thereof.

21. The method according to claim 13, wherein the transfer layer is formed using one of a deposition process and a wet process.

22. The method according to claim 13, wherein the base layer is formed of one of a glass substrate and a transparent polymer that is selected from a group consisting of polyester, polyacryl, polyepoxy, polyethylene, and polystyrene.

23. The method according to claim 13, wherein the light-to-heat conversion layer is formed of one selected from a group consisting of an organic layer, a metal, an oxide or sulfide of the metal, and an alloy thereof, that contain a light absorbing material.

24. The method according to claim 13,
wherein when the light-to-heat conversion layer is a metal layer, the light-to-heat conversion layer is formed using one selected from a group consisting of a vacuum deposition method, an electron-beam deposition method, and a sputtering method, and
wherein when the light-to-heat conversion layer is an organic layer, the light-to-heat conversion layer is formed using one selected from a group consisting of a roll coating process, a photogravure process, an extrusion process, a spin coating process, and a knife coating process.

25. The method according to claim 13, further comprising an intermediate layer interposed between the anti-static layer and the transfer layer,
wherein the intermediate layer includes at least one selected from a group consisting of a gas generation layer, a buffer layer, and a metal thin layer.

26. The method according to claim 13, wherein the transfer layer is formed using one selected from a group consisting of an extrusion process, a spin coating process, a knife coating process, a vacuum deposition process, and a chemical vapor deposition (CVD) process.

27. A method of fabricating an organic light emitting display, comprising:
patterning a first electrode on a substrate;
fixedly adsorbing the substrate to a stage that is transferable and grounded;
disposing the donor substrate of claim 1 opposite to a pixel region of the substrate, the donor substrate being fixed by a frame;
transferring an organic layer including at least an emission layer to the donor substrate by selectively irradiating laser beams on the donor substrate;
detaching the donor substrate from the substrate; and
forming a second electrode on the entire surface of the substrate including the organic layer.

28. The method according to claim 27, wherein the first electrode is one of an anode and a cathode.

29. The method according to claim 27, wherein the frame of the donor substrate is connected to the grounded stage.

30. The method according to claim 27, wherein the organic layer further includes at least one selected from a group consisting of an organic hole injection layer, an organic hole transport layer, an organic hole blocking layer, an organic electron injection layer, and an organic electron transport layer.

## Patentansprüche

1. Donorsubstrat zur laserinduzierten thermischen Strukturierung0, aufweisend:
eine Basisschicht;
eine Licht-zu-Wärme-Konversionsschicht, welche auf der gesamten Oberfläche der Basisschicht angeordnet ist;
eine antistatische Schicht, welche auf der gesamten Oberfläche der Licht-zu-Wärme-Konversionsschicht angeordnet ist;
eine Transferschicht, welche auf der gesamten Oberfläche der antistatischen Schicht angeordnet ist;
und
einen leitfähigen Rahmen, welcher auf einem äußeren Bereich des Donorsubstrats angeordnet ist und mit der antistatischen Schicht verbunden ist.

2. Donorsubstrat nach Anspruch 1, bei dem der leitfähige Rahmen aus einem Material besteht, welches aus einer Gruppe ausgewählt ist, die aus einem organischen Material, einem anorganischen Material und einer Kombination derselben besteht.

3. Donorsubstrat nach Anspruch 2, bei dem das organische Material aus einer Gruppe bestehend aus Polyanilin, Polypyrrol, Polythiophen und Poly(3,4-Ethylendioxythiophen) ausgewählt ist.

4. Donorsubstrat nach Anspruch 2, bei dem das anorganische Material aus einer Gruppe bestehend aus Antimonzinnoxid (ATO), Indiumzinnoxid (ITO), Indiumzinkoxid (IZO), Nb₂O₃, ZnO und TiN ausgewählt ist.

5. Donorsubstrat nach Anspruch 2, bei dem die Kombination aus dem organischen und dem anorganischen Material aus einer Gruppe bestehend aus einem ATO-Sol, einem ITO-Sol, Ag-Pd und Ag-Ru ausgewählt ist.

6. Donorsubstrat nach Anspruch 1, bei dem die antistatische Schicht aus einem leitfähigen Material ausgebildet ist.

7. Donorsubstrat nach Anspruch 6, bei dem das leitfähige Material aus einer Gruppe bestehend aus Polyanilin, Polypyrrol, Polythiophen, Poly(3,4-Ethylendioxythiophen), ATO, ITO, IZO, Nb₂O₃, ZnO, TiN, einem ATO-Sol, einem ITO-Sol, Ag-Pd und Ag-Ru ausgewählt ist.

8. Donorsubstrat nach Anspruch 1, bei dem die Licht-zu-Wärme-Konversionsschicht aus einer Gruppe bestehend aus einer organischen Schicht, einem Metall, einem Oxid oder Sulfid des Metalls und einer Legierung derselben ausgewählt ist, wobei die Elemente der besagten Gruppe ein Licht absorbierendes Material enthalten.

9. Donorsubstrat nach Anspruch 1, bei dem die Basisschicht aus einem Glassubstrat oder aus einem transparenten Polymer besteht, wobei das transparente Polymer aus einer Gruppe bestehend aus Polyester, Polyacryl, Polyepoxid, Polyethylen und Polystyrol ausgewählt ist.

10. Donorsubstrat nach Anspruch 1, weiterhin
enthaltend eine Zwischenschicht, welche zwischen der antistatischen Schicht und der Transferschicht angeordnet ist.

11. Donorsubstrat nach Anspruch 10, bei dem die Zwischenschicht zumindest eine Schicht aufweist,
welche aus einer Gruppe bestehend aus einer Gas erzeugenden Schicht, einer Pufferschicht und einer dünnen Metallschicht ausgewählt ist.

12. Donorsubstrat nach Anspruch 1, bei dem die Transferschicht aus einer Gruppe bestehend aus einer organischen Emissionsschicht, einer organischen Lochinjektionsschicht, einer organischen Lochtransportschicht, einer organischen Lochblockierschicht, einer organischen Elektroneninjektionsschicht, einer organischen Elektronentransportschicht und einer aus denselben ausgebildeten Verbundschicht ausgewählt ist.

13. Verfahren zur Herstellung eines Donorsubstrats zur laserinduzierten thermischen Strukturierung, aufweisend:
Bereitstellen einer Basisschicht;
Ausbilden einer Licht-zu-Wärme-Konversionsschicht auf der gesamten Oberfläche der Basisschicht;
Ausbilden einer antistatischen Schicht auf der gesamten Oberfläche der Licht-zu-Wärme-Konversionsschicht;
Ausbilden einer Transferschicht auf der antistatischen Schicht; und
Ausbilden eines leitfähigen Rahmens auf einem äußeren Bereich des resultierenden Donorsubstrats,
wobei die antistatische Schicht mit dem leitfähigen Rahmen verbunden ist.

14. Verfahren nach Anspruch 13, bei dem der leitfähige Rahmen aus einer Gruppe bestehend aus einem organischen Material, einem anorganischen Material und einer Kombination derselben ausgewählt ist.

15. Verfahren nach Anspruch 14, bei dem das organische Material aus einer Gruppe bestehend aus Polyanilin, Polypyrrol, Polythiophen und Poly(3,4-Ethylendioxythiophen) ausgewählt ist.

16. Verfahren nach Anspruch 14, bei dem das anorganische Material aus einer Gruppe bestehend aus ATO, ITO, IZO, Nb₂O₃, ZnO und TiN ausgewählt ist.

17. Verfahren nach Anspruch 14, bei dem die Kombination aus dem organischen und dem anorganischen Material aus einer Gruppe bestehend aus einem ATO-Sol, einem ITO-Sol, Ag-Pd und Ag-Ru ausgewählt ist.

18. Verfahren nach Anspruch 13, bei dem die antistatische Schicht aus einem leitfähigen Material ausgebildet ist.

19. Verfahren nach Anspruch 18, bei dem das leitfähige Material aus einer Gruppe bestehend aus Polyanilin, Polypyrrol, Polythiophen, Poly(3,4-Ethylendioxythiophen), ATO, ITO, IZO, Nb₂O₃, ZnO, TiN, einem ATO-Sol, einem ITO-Sol, Ag-Pd und Ag-Ru ausgewählt ist.

20. Verfahren nach Anspruch 13, bei dem die Transferschicht aus einer Gruppe bestehend aus einer organischen Emissionsschicht, einer organischen Lochinjektionsschicht, einer organischen Lochtransportschicht, einer organischen Lochblockierschicht, einer organischen Elektroneninjektionsschicht, einer organischen Elektronentransportschicht, und einer aus denselben bestehenden Verbundschicht ausgewählt ist.

21. Verfahren nach Anspruch 13, bei dem die Transferschicht unter Verwendung eines Abscheideverfahrens oder eines Nassverfahrens ausgebildet wird.

22. Verfahren nach Anspruch 13, bei dem die Basisschicht aus einem Glassubstrat oder aus einem transparenten Polymer ausgebildet wird, wobei das transparente Polymer aus einer Gruppe bestehend aus Polyester, Polyacryl, Polyepoxid, Polyethylen und Polystyrol ausgewählt ist.

23. Verfahren nach Anspruch 13, bei dem die Licht-zu-Wärme-Konversionsschicht aus einer Gruppe bestehend aus einer organischen Schicht, einem Metall, einem Oxid oder Sulfid des Metalls und einer Legierung derselben ausgewählt ist, wobei die Elemente der besagten Gruppe ein Licht absorbierendes Material enthalten.

24. Verfahren nach Anspruch 13, bei dem die Licht-zu-Wärme-Konversionsschicht unter Verwendung eines Verfahrens, welches aus einer Gruppe bestehend aus einem Vakuumabscheideverfahren, einem Elektronenstrahlgestützten Abscheideverfahren und einem Sputterverfahren ausgewählt ist, ausgebildet wird, sofern die Licht-zu-Wärme-Konversionsschicht eine Metallschicht ist, und
bei dem die Licht-zu-Wärme-Konversionsschicht unter Verwendung eines Verfahrens, welches aus einer Gruppe bestehend aus einem Walzenauftragsverfahren, einem Kupfertieidruckverfahren, einem Extrusionsverfahren, einem Spin-Coating-Verfahren und einem Rakelverfahren ausgewählt ist, ausgebildet wird, wenn die Licht-zu-Wärme-Konversionsschicht eine organische Schicht ist.

25. Verfahren nach Anspruch 13, weiterhin
aufweisend eine Zwischenschicht, welche zwischen der antistatischen Schicht und der Transferschicht angeordnet ist, wobei die Zwischenschicht zumindest eine Schicht aufweist,
welche aus einer Gruppe bestehend aus einer Gas erzeugenden Schicht, einer Pufferschicht und einer dünnen Metallschicht ausgewählt ist.

26. Verfahren nach Anspruch 13, bei dem die Transferschicht unter Verwendung eines Verfahrens, welches aus einer Gruppe bestehend aus einem Extrusionsverfahren, einem Spin-Coating-Verfahren, einem Rakelverfahren, einem Vakuumabscheideverfahren und einem Verfahren zur chemischen Gasphasenabscheidung (CVD) ausgewählt ist, ausgebildet wird.

27. Verfahren zur Herstellung einer organischen lichtemittierenden Anzeige, aufweisend:
Strukturieren einer ersten Elektrode auf einem Substrat;
Festlegen des Substrats an eine Plattform, die beweglich und geerdet ist;
Anordnen des Donorsubstrats nach Anspruch 1 derart, dass es einer Pixelregion des Substrats gegenüberliegt, wobei das Donorsubstrat durch einen Rahmen fixiert wird;
Übertragen einer organischen Schicht, welche zumindest eine Emissionsschicht aufweist, zu einem Donorsubstrat durch selektives Bestrahlen des Donorsubstrats mit Laserstrahlen;
Ablösen des Donorsubstrats vom Substrat; und
Ausbilden einer zweiten Elektrode auf der gesamten Oberfläche des Substrats, welches die organische Schicht aufweist.

28. Verfahren nach Anspruch 27, bei dem die erste Elektrode eine Anode oder eine Kathode ist.

29. Verfahren nach Anspruch 27, bei dem der Rahmen des Donorsubstrats mit der geerdeten Plattform verbunden wird.

30. Verfahren nach Anspruch 27, bei dem die organische Schicht weiterhin zumindest eine Schicht umfasst,
welche aus einer Gruppe bestehend aus einer organischen Lochinjektionsschicht, einer organischen Lochtransportschicht, einer organischen Lochblockierschicht, einer organischen Elektroneninjektionsschicht und einer organischen Elektronentransportschicht ausgewählt ist.

## Revendications

1. Substrat donneur pour la formation thermique d'images induites par laser comprenant :
une couche de base ;
une couche de conversion lumière en chaleur disposée sur la surface entière de la couche de base ;
une couche antistatique disposée sur la surface entière de la couche de conversion lumière en chaleur;
une couche de transfert disposée sur la surface entière de la couche antistatique ; et
un cadre conducteur disposé sur une partie extérieure du substrat donneur et connecté à la couche antistatique.

2. Substrat donneur selon la revendication 1, dans lequel le cadre conducteur est formé d'un matériau sélectionné parmi un groupe comprenant un matériau organique, un matériau inorganique et une combinaison de ceux-ci.

3. Substrat donneur selon la revendication 2, dans lequel le matériau organique est un matériau sélectionné parmi un groupe comprenant la polyaniline, le polypyrrole, le polythiophène et le poly(3,4-éthylène-dioxythiophène).

4. Substrat donneur selon la revendication 2, dans lequel le matériau inorganique est un matériau sélectionné parmi un groupe comprenant l'oxyde d'étain d'antimoine (ATO), l'oxyde d'étain d'indium (ITO), l'oxyde de zinc d'indium (IZO), le Nb₂O₃, le ZnO et le TiN.

5. Substrat donneur selon la revendication 2, dans lequel la combinaison des matériaux organiques et inorganiques est une combinaison sélectionnée parmi un groupe comprenant un sol ATO, un sol ITO, Ag-Pd et Ag-Ru.

6. Substrat donneur selon la revendication 1, dans lequel la couche antistatique est formée d'un matériau conducteur.

7. Substrat donneur selon la revendication 6, dans lequel le matériau conducteur est un matériau sélectionné parmi un groupe comprenant la polyaniline, le polypyrrole, le polythiophène, le poly(3,9-éthylène-dioxythiophène), l'ATO, l'ITO, l'IZO, le Nb₂O₃, le ZnO, le TiN, un sol ATO, un sol ITO, Ag-Pd et Ag-Ru.

8. Substrat donneur selon la revendication 1, dans lequel la couche de conversion lumière en chaleur est formée d'une couche sélectionnée parmi un groupe comprenant une couche organique, un métal, un oxyde ou un sulfure du métal, et un alliage de ceux-ci, qui contient un matériau absorbant la lumière.

9. Substrat donneur selon la revendication 1, dans lequel la couche de base est formée d'un parmi un substrat de verre et un polymère transparent, qui est sélectionné parmi un groupe comprenant le polyester, le polyacryl, le polyépoxy, le polyéthylène et le polystyrène.

10. Substrat donneur selon la revendication 1, comprenant de plus une couche intermédiaire interposée entre la couche antistatique et la couche de transfert.

11. Substrat donneur selon la revendication 10, dans lequel la couche intermédiaire comprend au moins une couche sélectionnée parmi un groupe comprenant une couche de génération de gaz, une couche tampon et une couche mince de métal.

12. Substrat donneur selon la revendication 1, dans lequel la couche de transfert est une couche sélectionnée parmi un groupe comprenant une couche d'émission organique, une couche d'injection de trous organique, une couche de transport de trous organique, une couche de blocage de trous organique, une couche d'injection d'électrons organique, une couche de transport d'électrons organique et une couche laminée de celles-ci.

13. Procédé de fabrication d'un substrat donneur pour la formation thermique d'images induites par laser comprenant les étapes qui consistent à :
fournir une couche de base ;
former une couche de conversion lumière en chaleur sur la surface entière de la couche de base ;
former une couche antistatique sur la surface entière de la couche de conversion lumière en chaleur ;
former une couche de transfert sur la couche antistatique ; et
former un cadre conducteur sur une partie extérieure du substrat donneur résultant ;
dans lequel la couche antistatique est connectée au cadre conducteur.

14. Procédé selon la revendication 13, dans lequel le cadre conducteur est formé d'un matériau sélectionné parmi un groupe comprenant un matériau organique, un matériau inorganique et une combinaison de ceux-ci.

15. Procédé selon la revendication 14, dans lequel le matériau organique est un matériau sélectionné parmi un groupe comprenant la polyaniline, le polypyrrole, le polythiophène et le poly(3,4-éthylène-dioxythiophène).

16. Procédé selon la revendication 14, dans lequel le matériau inorganique est un matériau sélectionné parmi un groupe comprenant l'ATO, l'ITO, l'IZO, le Nb₂O₃, le ZnO et le TiN.

17. Procédé selon la revendication 14, dans lequel la combinaison des matériaux organiques et inorganiques est une combinaison sélectionnée parmi un groupe comprenant un sol ATO, un sol ITO, Ag-Pd et Ag-Ru.

18. Procédé selon la revendication 13, dans lequel la couche antistatique est formée d'un matériau conducteur.

19. Procédé selon la revendication 18, dans lequel le matériau conducteur est un matériau sélectionné parmi un groupe comprenant la polyaniline, le polypyrrole, le polythiophène, le poly(3,4-éthylène-dioxythiophène), l'ATO, l' ITD, l'IZO, le Nb₂O₃, le ZnO, le TiN, un sol ATO, un sol ITO, Ag-Pd et Ag-Ru.

20. Procédé selon la revendication 13, dans lequel la couche de transfert est une couche sélectionnée parmi un groupe comprenant une couche d'émission organique, une couche d'injection de trous organique, une couche de transport de trous organique, une couche de blocage de trous organique, une couche d'injection d'électrons organique, une couche de transport d'électrons organique et une couche laminée de celles-ci.

21. Procédé selon la revendication 13, dans lequel la couche de transfert est formée en utilisant un des procédés parmi un procédé de dépôt et un procédé par voie humide.

22. Procédé selon la revendication 13, dans lequel la couche de base est formée d'un parmi un substrat de verre et un polymère transparent, qui est sélectionné parmi un groupe comprenant le polyester, le polyacryl, le polyépoxy, le polyéthylène et le polystyrène.

23. Procédé selon la revendication 13, dans lequel la couche de conversion lumière en chaleur est formée d'une couche sélectionnée parmi un groupe comprenant une couche organique, un métal, un oxyde ou un sulfure du métal, et un alliage de ceux-ci, qui contiennent un matériau absorbant la lumière.

24. Procédé selon la revendication 13,
dans lequel, lorsque la couche de conversion lumière en chaleur est une couche métallique, la couche de conversion lumière en chaleur est formée en utilisant un procédé sélectionné parmi un groupe comprenant un procédé de dépôt par évaporation sous vide, un procédé de dépôt par projection de faisceau d'électrons et un procédé de dépôt par pulvérisation cathodique, et
dans lequel, lorsque la couche de conversion lumière en chaleur est une couche organique, la couche de conversion lumière en chaleur est formée en utilisant un procédé sélectionné parmi un groupe comprenant un procédé de revêtement au rouleau, un procédé de photogravure, un procédé d'extrusion, un procédé d'enduction à la tournette et un procédé d'enduction à la racle.

25. Procédé selon la revendication 13, comprenant de plus une couche intermédiaire interposée entre la couche antistatique et la couche de transfert,
dans lequel la couche intermédiaire comprend au moins une couche sélectionnée parmi un groupe comprenant une couche de génération de gaz, une couche tampon et une couche mince de métal.

26. Procédé selon la revendication 13, dans lequel la couche de transfert est formée en utilisant un procédé sélectionné parmi un groupe comprenant un procédé d'extrusion, un procédé d'enduction à la tournette, un procédé d'enduction à la racle, un procédé de dépôt par évaporation sous vide et un procédé de dépôt par réaction chimique en phase vapeur.

27. Procédé de fabrication d'un afficheur électroluminescent organique comprenant les étapes qui consistent à :
modeler les contours d'une première électrode sur un substrat ;
adsorber de manière fixe le substrat sur un étage qui est transférable et mis à la terre ;
déposer le substrat donneur de la revendication 1 en face d'une région de pixels du substrat, le substrat donneur étant fixé par un cadre ;
transférer une couche organique comprenant au moins une couche d'émission sur le substrat donneur en irradiant de manière sélective des faisceaux laser sur le substrat donneur
détacher le substrat donneur du substrat ; et
former une deuxième électrode sur la surface entière du substrat comprenant la couche organique.

28. Procédé selon la revendication 27, dans lequel la première électrode est une parmi une anode et une cathode.

29. Procédé selon la revendication 27, dans lequel le cadre du substrat donneur est connecté à l'étage mis à la terre.

30. Procédé selon la revendication 27, dans lequel la couche organique comprend de plus au moins une couche sélectionnée parmi un groupe comprenant une couche d'injection de trous organique, une couche de transport de trous organique, une couche de blocage de trous organique, une couche d'injection d'électrons organique et une couche de transport d'électrons organique.
